(19) Europäisches Patentamt / European Patent Office / Office européen des brevets

(11) **EP 2 930 506 B1**

## (12) FASCICULE DE BREVET EUROPEEN

(45) Date de publication et mention
de la délivrance du brevet:
**08.05.2019 Bulletin 2019/19**

(51) Int Cl.:
**G01N 29/036** *(2006.01)* **G01N 29/22** *(2006.01)*
**G01N 29/24** *(2006.01)* **G01N 21/03** *(2006.01)*
**G01N 21/17** *(2006.01)* **H01S 5/026** *(2006.01)*

(21) Numéro de dépôt: **15162230.5**

(22) Date de dépôt: **01.04.2015**

(54) **DISPOSITIF DE DETECTION A RESONATEUR ACOUSTIQUE DIFFERENTIEL DE TYPE HELMHOLTZ**

ERKENNUNGSVORRICHTUNG MIT AKUSTISCHEM RESONATOR FÜR DIFFERENTIALANWENDUNGEN VOM TYP HELMHOLTZ-RESONATOR

DETECTION DEVICE WITH HELMHOLTZ DIFFERENTIAL ACOUSTIC RESONATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.04.2014 FR 1453101**

(43) Date de publication de la demande:
**14.10.2015 Bulletin 2015/42**

(73) Titulaire: **Commissariat à l'Énergie Atomique et aux Énergies Alternatives**
**75015 Paris (FR)**

(72) Inventeurs:
• **Gliere, Alain**
**38000 GRENOBLE (FR)**
• **Boutami, Salim**
**38100 GRENOBLE (FR)**
• **Brun, Mickaël**
**38320 EYBENS (FR)**
• **Labeye, Pierre**
**38000 GRENOBLE (FR)**
• **Nicoletti, Sergio**
**38650 SINARD (FR)**
• **Rouxel, Justin**
**38400 SAINT-MARTIN-D'HERES (FR)**

(74) Mandataire: **Brevalex**
**95, rue d'Amsterdam**
**75378 Paris Cedex 8 (FR)**

(56) Documents cités:
**EP-A1- 2 515 096    EP-A2- 2 402 735**

• **FIREBAUGH SAMARA L ET AL: "Miniaturization and integration of photoacoustic detection", JOURNAL OF APPLIED PHYSICS, AMERICAN INSTITUTE OF PHYSICS, US, vol. 92, no. 3, 1 août 2002 (2002-08-01), pages 1555-1563, XP012056999, ISSN: 0021-8979, DOI: 10.1063/1.1489493**

# EP 2 930 506 B1

**Description**

## DOMAINE TECHNIQUE ET ART ANTÉRIEUR

L'invention concerne le domaine des dispositifs de détection photoacoustique, et notamment celui des capteurs de gaz intégrés faisant appel à un effet photoacoustique pour mesurer la concentration de certains éléments gazeux.

Le principe d'une mesure d'un gaz par effet photoacoustique repose sur l'excitation d'une onde acoustique dans le gaz par une source lumineuse puissante telle qu'un laser pulsé ou modulé en amplitude ou en longueur d'onde. La longueur d'onde du rayonnement moyen-infrarouge (MIR) émis par le laser est choisie pour interagir spécifiquement avec les molécules du gaz à détecter. L'émission de la source lumineuse étant variable dans le temps, l'énergie absorbée par les molécules gazeuses est restituée sous la forme d'un échauffement transitoire qui génère une onde de pression, elle-même mesurée par un détecteur acoustique.

La détection est améliorée en confinant le gaz dans une cavité et en modulant le laser à une fréquence de résonance acoustique de la cavité. L'amplitude de l'onde acoustique obtenue est directement liée à la concentration du composé gazeux recherché dans le gaz présent dans la cavité excitée.

L'efficacité de la détection repose en grande partie sur le couplage efficace du flux lumineux issu du laser avec le gaz contenu dans la cavité résonnante car le signal mesuré est proportionnel à l'énergie absorbée, puis dissipée, par le gaz.

Le document WO 03/083455 A1 décrit un dispositif de mesure photoacoustique permettant de détecter la présence d'un gaz et comportant une structure particulière de cellule photoacoustique dite « Differential Helmholtz Resonator » (DHR), ou résonateur acoustique différentiel de type Helmholtz. Un tel résonateur comporte deux chambres identiques reliées entre elles par deux capillaires.

La résonance acoustique est produite en excitant une seule des deux chambres. A la résonance, les pressions dans les deux chambres oscillent en opposition de phase. Les pressions dans les chambres sont mesurées par des microphones placés dans les deux chambres. Avec un tel résonateur, le calcul de la différence entre les signaux issus de chaque chambre, qui correspond au signal utile, permet d'augmenter l'amplitude du signal mesuré et d'éliminer une partie du bruit environnant, et donc d'avoir au final un bon rapport signal sur bruit. Un autre type de résonateur photoacoustique différentiel est décrit dans le document WO 2008/074442 A1.

De tels dispositifs ont toutefois pour inconvénients d'être limités à des appareils de laboratoire non miniaturisés, d'avoir des longueurs d'onde de transmission limitées, d'être sensibles aux variations de température et aux vibrations, et d'avoir de fortes contraintes de positionnement et d'alignement de leurs éléments pour leur réalisation.

Une miniaturisation d'un tel dispositif à l'échelle millimétrique est proposée dans le document US 7,304,732 B1. Cette miniaturisation permet d'avoir un plus fort signal de pression produit par le capteur du fait que ce signal croît quand la taille du résonateur est réduite. Les résonateurs DHR sont particulièrement bien adaptés à la miniaturisation et à l'intégration sur silicium car ils sont relativement insensibles à la localisation du dépôt d'énergie thermique et car, la pression étant quasi-constante dans chaque chambre, il est possible de multiplier le nombre de microphones par chambre pour améliorer le rapport signal sur bruit.

Le document EP 2 515 096 A1 décrit un dispositif de détection de gaz photoacoustique comportant un résonateur photoacoustique miniaturisé intégré sur silicium. La structure de ce détecteur est obtenue par la mise en oeuvre de techniques du domaine de la microélectronique dans plusieurs substrats collés entre eux. Le processus de fabrication impose de placer le guide d'onde MIR, qui permet d'injecter le signal optique laser dans l'une des deux chambres, dans la partie inférieure du substrat central qui est aminci à une épaisseur déterminée par la hauteur des chambres.

La miniaturisation et l'intégration sur silicium de ce type de détecteur posent toutefois un problème. En effet, le rayonnement MIR produit par le laser est transmis jusqu'à la chambre excitée par un guide d'onde de section comparable à la longueur d'onde du rayonnement. A l'entrée de la chambre excitée, le faisceau subit une diffraction due notamment à la faible épaisseur du silicium, ce qui conduit à une importante divergence du faisceau. Cette divergence du faisceau lumineux, alliée à la transparence du silicium (dans lequel est fabriqué le résonateur), conduit à un mauvais confinement de la lumière et donc à un mauvais couplage lumière-gaz. Ce phénomène est exacerbé par le fait que le flux lumineux pénètre à proximité du bas de la chambre. De plus, ce mauvais confinement peut entraîner une illumination partielle de la deuxième chambre (phénomène de diaphonie), ce qui réduit l'amplitude du signal utile obtenu.

## EXPOSÉ DE L'INVENTION

Un but de la présente invention est de proposer un dispositif de détection photoacoustique de type DHR et intégré, et dans lequel le confinement du faisceau lumineux destiné à être injecté dans l'une des chambres du dispositif soit amélioré.

Pour cela, la présente invention propose un dispositif de détection photoacoustique comprenant :

- au moins un substrat comportant des cavités formant un résonateur acoustique différentiel de type Helmholtz (ou DHR);
- des détecteurs acoustiques couplés à deux desdites cavités formant des chambres du résonateur ;
- une source lumineuse apte à émettre un faisceau lumineux à au moins une longueur d'onde donnée ;
- un guide d'onde optique comportant une première extrémité couplée optiquement à la source lumineuse et une deuxième extrémité couplée optiquement à une première des deux chambres ;

dans lequel la deuxième extrémité comporte, au niveau d'une interface avec la première chambre, une largeur de valeur supérieure à celle de la largeur de la première extrémité et supérieure à celle de ladite au moins une longueur d'onde donnée, et/ou dans lequel le dispositif de détection photoacoustique comporte au moins un réseau de diffraction disposé dans la deuxième extrémité du guide d'onde et apte à diffracter une première partie du faisceau lumineux vers une couche réflectrice inférieure disposée sous la deuxième extrémité et une deuxième partie du faisceau lumineux vers une couche réflectrice supérieure disposée au niveau d'une paroi supérieure de la première chambre.

Dans ce dispositif de détection photoacoustique, le confinement du faisceau lumineux est amélioré horizontalement via l'élargissement de la deuxième extrémité du guide d'onde qui est couplée optiquement à la première chambre qui est destinée à recevoir le faisceau lumineux, du fait que cet élargissement permet de réduire voire d'annuler la diffraction du faisceau lumineux dans la direction parallèle à cette largeur. Le confinement du faisceau lumineux est en outre amélioré verticalement grâce au réseau de diffraction qui permet de diffracter le faisceau lumineux dans une direction spécifique vers les couches réflectrices qui permettent de confiner le faisceau lumineux dans la première chambre.

Le terme « largeur» est utilisé ici et dans tout le reste du document pour désigner, en liaison avec le guide d'onde, la dimension qui se trouve dans un plan de propagation du faisceau lumineux dans le guide d'onde et qui est perpendiculaire ou sensiblement perpendiculaire à une direction de propagation du faisceau lumineux dans le guide d'onde. Plus généralement le terme « largeur» désigne la dimension qui est perpendiculaire ou sensiblement perpendiculaire à une direction de propagation du faisceau lumineux dans le guide d'onde optique.

De préférence, le guide d'onde optique peut être tel qu'il fonctionne sur le mode fondamental pour lequel le réseau de diffraction est dimensionné et diffracte à un angle bien précis. Un tel fonctionnement monomode du guide d'onde optique est avantageux car il permet un meilleur contrôle de la direction du faisceau lumineux. Si plusieurs modes sont excités, ces modes peuvent diffracter dans plusieurs directions. Toutefois, dans le cas d'un guide d'onde multimodes, un faible écart d'indice entre le coeur et la gaine du guide d'onde peut permettre de limiter la variation de l'indice effectif du guide.

Avantageusement, le dispositif de détection photoacoustique comporte à la fois un guide d'onde optique dont la deuxième extrémité a, au niveau d'une interface avec la première chambre, une largeur supérieure à celle de la première extrémité et à ladite longueur d'onde donnée, et le réseau de diffraction disposé dans la deuxième extrémité du guide d'onde et couplé aux couches réflectrices inférieure et supérieure. Cette configuration permet d'améliorer le confinement horizontal et vertical du faisceau lumineux.

La valeur de la largeur de la deuxième extrémité est de préférence supérieure ou égale à plusieurs fois celle de ladite longueur d'onde donnée.

Le dispositif de détection de type « DHR » de l'invention est un dispositif microélectronique, c'est-à-dire obtenu par des étapes successives de dépôt de couches, de gravure, et éventuellement de planarisation, d'implantation et de report. Une tel dispositif microélectronique occupe préférentiellement, sur le substrat, une surface inférieure à environ 25 mm$^2$.

La couche réflectrice inférieure correspond à la couche réflectrice inférieure du guide d'onde optique.

La paroi supérieure de la première chambre est formée par la couche réflectrice supérieure.

Le dispositif selon l'invention fonctionne lorsque le guide d'onde comporte une deuxième extrémité plus large que la première extrémité et qu'il comporte le réseau de diffraction disposé dans la deuxième extrémité du guide d'onde. Toutefois, le dispositif fonctionne également lorsque le guide d'onde comporte une deuxième extrémité plus large que la première extrémité mais qu'il ne comporte pas le réseau de diffraction, ou bien lorsque le guide d'onde ne comporte pas une deuxième extrémité plus large que la première extrémité mais que le réseau de diffraction est disposé dans cette deuxième extrémité.

Un rapport entre la largeur de la deuxième extrémité au niveau de l'interface avec la première chambre et la largeur de la première extrémité peut être supérieur ou égal à 3.

La deuxième extrémité peut former une portion du guide d'onde dont la largeur croit depuis une première valeur égale à celle de la largeur de la première extrémité jusqu'à une deuxième valeur égale à celle de la largeur de la deuxième extrémité au niveau de l'interface avec la première chambre.

Dans ce cas, la largeur de la deuxième extrémité peut croitre sur une partie, appelée première partie, de la deuxième extrémité dont la longueur peut être supérieure ou égale à environ dix fois la largeur de la deuxième extrémité au niveau de l'interface avec la première chambre. Le terme « longueur » désigne ici, en liaison avec le guide d'onde, la dimension qui se trouve dans le plan de propagation du faisceau lumineux dans le guide d'onde et qui est parallèle à la direction de propagation du faisceau lumineux dans le guide d'onde (et donc perpendiculaire à la largeur précédemment définie). Les termes « épaisseur » et « hauteur » font référence à la dimension qui est perpendiculaire à la largeur et à la longueur. Une telle croissance progressive de la largeur de la deuxième extrémité du guide d'onde permet de bien conserver le caractère monomode de la transmission du faisceau lumineux réalisée par le guide d'onde.

Le réseau de diffraction peut être disposé dans une partie, appelée deuxième partie, de la deuxième extrémité dont la largeur peut être sensiblement constante et égale à celle au niveau de l'interface avec la première chambre.

Le réseau de diffraction peut être disposé au niveau d'une interface entre une couche de coeur du guide d'onde et une couche de gainage inférieure du guide d'onde, la couche de gainage inférieure pouvant être disposée entre la couche de coeur et la couche réflectrice inférieure.

Le réseau de diffraction peut être apte à diffracter le faisceau lumineux tel que la première ou la deuxième partie du faisceau lumineux atteigne, après une réflexion sur la couche réflectrice inférieure et/ou la couche réflectrice supérieure, une paroi de fond de la première chambre qui est opposée à celle en contact avec la deuxième extrémité du guide d'onde. Ainsi, le réseau de diffraction peut être dimensionné, notamment en ce qui concerne le pas du réseau, tel que le trajet du faisceau lumineux soit maximisé dans la première chambre pour la première ou la deuxième partie du faisceau lumineux. Bien que cette configuration soit avantageuse, il est tout à fait possible que le réseau de diffraction ne soit pas dimensionné pour que la première ou la deuxième partie du faisceau lumineux atteigne, après une réflexion sur la couche réflectrice inférieure et/ou la couche réflectrice supérieure, la paroi de fond de la première chambre.

Les détecteurs acoustiques peuvent être disposés dans un premier substrat et être couplés aux chambres du résonateur formées dans un deuxième substrat solidarisé au premier substrat, des volumes des chambres pouvant communiquer entre eux par des capillaires formés dans un troisième substrat solidarisé au deuxième substrat.

En variante, les détecteur acoustiques peuvent être disposés dans un premier substrat et être couplés aux chambres du résonateur formées dans un deuxième substrat solidarisé au premier substrat, des volumes des chambres communiquant entre eux par des capillaires formés dans le deuxième substrat, le deuxième substrat ayant une épaisseur inférieure à 300 $\mu$m. Ainsi, en formant les capillaires et les chambres dans un même substrat, il est possible de réduire l'épaisseur des chambres, et éventuellement celle des capillaires, à une valeur inférieure à 300 $\mu$m.

Le dispositif peut comporter en outre des tranchées remplies d'au moins un matériau optiquement réfléchissant et disposées autour de la première chambre, et notamment autour des parois latérales de la première chambre. De telles tranchées contribuent à améliorer le confinement horizontal (c'est-à-dire dans la direction parallèle à la largeur du guide d'onde) du faisceau lumineux.

Les deux chambres peuvent comporter des dimensions différentes l'une par rapport à l'autre. Une telle asymétrie des chambres peut permettre d'optimiser l'opposition de phase des signaux acoustiques mesurés dans les deux chambres.

Les détecteurs acoustiques peuvent comporter des microphones piézorésistifs de type poutre.

L'invention concerne également un dispositif de détection de gaz, comportant au moins un dispositif de détection photoacoustique tel que décrit précédemment et comportant en outre des canaux d'entrée et de sortie de gaz communiquant avec les chambres du résonateur, par exemple par l'intermédiaire des capillaires, et dans lequel la longueur d'onde destinée à être émise par la source lumineuse correspond à une longueur d'onde d'absorption d'un gaz destiné à être détecté. Un tel dispositif forme ainsi un capteur des gaz à faible coût pouvant être utilisé par exemple dans le domaine de la détection de gaz en extérieur (détection de pollution, mesure des gaz à effet de serre, etc.) ou en intérieur (qualité de l'air intérieur, climatisation, détection de substances dans espace intérieur, etc.).

L'invention concerne également un procédé de réalisation d'un dispositif de détection photoacoustique, comportant au moins les étapes de :

- réalisation, dans au moins un substrat, d'un guide d'onde optique comportant une première extrémité et une deuxième extrémité,
- réalisation d'une source lumineuse apte à émettre un faisceau lumineux à au moins une longueur d'onde donnée et telle que la source lumineuse soit couplée optiquement à la première extrémité du guide d'onde,
- réalisation, dans ledit au moins un substrat, de cavités formant un résonateur acoustique différentiel de type Helmholtz, deux desdites cavités formant des chambres du résonateur telles qu'une première des deux chambres soit couplée optiquement avec la deuxième extrémité du guide d'onde,
- couplage de détecteurs acoustiques avec les chambres du résonateur,

dans lequel la deuxième extrémité comporte, au niveau d'une interface avec la première chambre, une largeur de valeur supérieure à celle de la largeur de la première extrémité et supérieure à celle de ladite au moins une longueur d'onde donnée, et/ou dans lequel le procédé comporte la réalisation d'au moins un réseau de diffraction dans la deuxième extrémité du guide d'onde apte à diffracter une première partie du faisceau lumineux vers une couche réflectrice inférieure disposée sous la deuxième extrémité et une deuxième partie du faisceau lumineux vers une couche réflectrice supérieure disposée au niveau d'une paroi supérieure de la première chambre.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente de manière schématique un dispositif de détection photoacoustique, objet de la présente invention, selon un mode de réalisation particulier,
- la figure 2 représente de manière schématique un exemple de réalisation d'une deuxième extrémité du guide d'onde du dispositif de détection photoacoustique, objet de la présente invention,
- la figure 3 représente de manière schématique une partie du dispositif de détection photoacoustique, objet de la présente invention,
- la figure 4 représente l'amplitude du signal mesuré par le dispositif de détection de gaz, objet de la présente invention, en fonction de la différence entre les largeurs des chambres du dispositif,
- la figure 5 représente l'amplitude du signal mesuré par le dispositif de détection de gaz, objet de la présente invention, pour différentes distances entre les capillaires et pour des chambres de dimensions différentes,
- les figures 6A à 6I représentent les étapes d'un procédé de réalisation d'un dispositif de détection photoacoustique, objet de la présente invention,

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

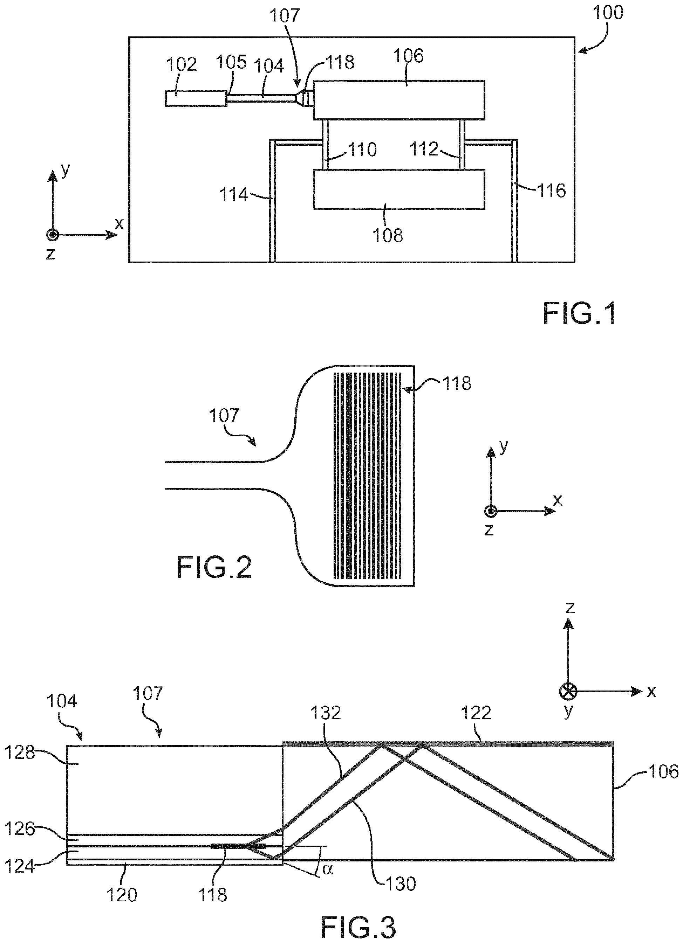

On se réfère tout d'abord à la figure 1 qui représente schématiquement un dispositif de détection photoacoustique 100 selon un mode de réalisation particulier. Ce dispositif de détection photoacoustique 100 correspond à un dispositif de détection de gaz.

Le dispositif 100 comporte une source lumineuse 102 puissante, correspondant ici à un laser. Ce laser peut correspondre à un laser de type QCL (laser à cascade quantique) émettant dans le domaine MIR, par exemple à des longueurs d'ondes comprises entre environ 3 $\mu$m et 10 $\mu$m. Bien que non représentés, le dispositif 100 comporte également une alimentation électrique de la source lumineuse 102 ainsi que des moyens de modulation du faisceau lumineux émis à une fréquence de résonance acoustique de la cavité dans laquelle le faisceau est destiné à être envoyé. Par rapport à l'utilisation d'une source lumineuse 102 qui ne serait pas collimatée, l'utilisation d'une source lumineuse 102 collimatée dans le dispositif 100 permet d'augmenter grandement le facteur signal/bruit, par exemple d'un facteur 2. Le bruit de fenêtre correspond au signal acoustique parasite que toutes les parties solides émettent lorsqu'elles sont frappées par l'onde lumineuse modulée.

Le faisceau lumineux émis est ensuite transmis dans un guide d'onde optique 104, avantageusement monomode et par exemple formé d'un empilement Si/Ge/Si, ou SiN/Si/SiN, ou plus généralement d'un empilement d'un premier matériau d'indice optique ni, d'un deuxième matériau d'indice optique $n_2 > $ ni, et d'un troisième matériau d'indice optique $n_3 < n_2$ (avec $n_3$ éventuellement égal à ni), ces trois matériaux étant transparents à la longueur d'onde émise par la source lumineuse 102. Le guide d'onde optique 104 comporte une première extrémité 105 couplée optiquement à la source lumineuse 102. Le couplage entre la source lumineuse 102 et le guide d'onde 104 peut être réalisé directement, par exemple par ondes évanescentes, ou via l'utilisation d'un coupleur (non représenté sur la figure 1) par exemple de type taper (formant un trapèze allongé extrudé).

Le dispositif 100 comporte également des éléments correspondant à des cavités, ou évidements, formés dans un ou plusieurs substrats solidaires les uns des autres, et formant un résonateur acoustique différentiel de type Helmholtz (DHR). Ces éléments sont :

- une première chambre 106 dans laquelle le gaz à détecter est destiné à être excité par le faisceau lumineux émis par la source 102, et dont une face d'entrée destinée à recevoir le faisceau lumineux est couplée optiquement à une deuxième extrémité 107 du guide d'onde 104 ;
- une deuxième chambre 108 ;
- deux capillaires 110 et 112 permettant de faire communiquer les volumes des chambres 106 et 108 entre eux.

Le dispositif 100 comporte également un canal d'entrée 114 permettant d'amener le gaz dans les chambres 106 et 108 via le capillaire 110, et un canal de sortie 116 permettant d'évacuer le gaz hors des chambres 106 et 108 via le capillaire 112. Sur la figure 1, les canaux d'entrée 114 et de sortie 116 sont reliés aux capillaires 110 et 112 sensiblement au niveau du milieu de ces capillaires 110, 112. Des détecteurs acoustiques (non visibles sur la figure 1) tels que des microphones miniaturisés piézorésistifs, par exemple de type membrane ou poutre, sont également couplés aux chambres 106, 108 afin de réaliser les mesures de pression dans les chambres 106, 108. Chacune des chambres 106, 108 peut être couplée à un ou plusieurs microphones, par exemple jusqu'à huit microphones par chambre. Enfin, le dispositif 100 comporte également des circuits électroniques de traitement des signaux délivrés par les détecteurs acoustiques qui ne sont pas représentés sur la figure 1.

Le principe de fonctionnement du dispositif 100 est similaire à celui décrit dans le document EP 2 515 096 A1 et n'est donc pas décrit en détail ici.

Afin de confiner le faisceau lumineux dans la première chambre 106 et ainsi améliorer le couplage lumière-gaz se produisant dans la première chambre 106, le dispositif 100 comporte un élément permettant de contrôler la divergence horizontale (selon l'axe y représenté sur la figure 1) du faisceau lumineux à l'interface entre la première chambre 106 et la deuxième extrémité 107 du guide d'onde 104, et un élément permettant de contrôler la divergence verticale (selon l'axe z représenté sur la figure 1) du faisceau lumineux à cette interface.

Ainsi, à l'interface avec la première chambre 106, la deuxième extrémité 107 du guide d'onde 104 est réalisée telle que sa largeur (dimension selon l'axe y), c'est-à-dire sa dimension se trouvant dans le plan de propagation du faisceau lumineux et qui est perpendiculaire à la direction de propagation du faisceau lumineux, augmente afin de réaliser le confinement horizontal du faisceau lumineux du fait que cet accroissement de la largeur de la deuxième extrémité 107 du guide d'onde 104 entraine une réduction de la diffraction dans la direction de cet élargissement. Cet élargissement de la deuxième extrémité 107 du guide d'onde 104 est représenté schématiquement sur la figure 2 qui représente une vue de dessus du guide d'onde 104 au niveau de sa deuxième extrémité 107 qui se trouve à l'interface avec la première chambre 106. Cet élargissement de la deuxième extrémité 107 du guide d'onde 104 est progressif et de préférence tel qu'il conserve le caractère monomode de la transmission du faisceau lumineux jusque dans la première chambre 106. Un tel élargissement peut être qualifié d'adiabatique lorsque l'indice effectif varie linéairement et qu'il permet de conserver le caractère monomode tout en minimisant la longueur de cette deuxième extrémité 107. La deuxième extrémité 107 du guide d'onde 104 peut par exemple avoir une largeur initiale, égale à celle du reste du guide d'onde 104 et notamment égale à celle au niveau de la première extrémité 105, égale à environ 3 $\mu$m, ou comprise entre environ 3 $\mu$m et 8 $\mu$m, et une largeur finale (largeur au niveau de l'interface avec la première chambre 106) égale à environ 30 $\mu$m, ou comprise entre environ 30 $\mu$m et 40 $\mu$m ou entre environ 30 $\mu$m et 50 $\mu$m, c'est-à-dire ici un rapport entre la largeur finale et la largeur initiale compris entre environ 10 et 13,33. Le rapport entre la largeur finale et la largeur initiale est par exemple compris entre environ 3 et 20, et par exemple d'environ 10. Afin de conserver le caractère monomode de la transmission du faisceau lumineux jusque dans la chambre 106, cet élargissement est par exemple réalisé sur une longueur d'environ 300 $\mu$m, ou comprise entre environ 50 $\mu$m et 500 $\mu$m. La valeur de la largeur initiale peut être de l'ordre de celle de la longueur d'onde du faisceau lumineux émis pour réaliser un guidage monomode de ce faisceau lumineux, et la valeur de la largeur finale est supérieure à celle de cette longueur d'onde pour obtenir un confinement horizontal du faisceau lumineux.

Le contrôle de la divergence verticale du faisceau lumineux est réalisé grâce à un réseau de diffraction 118 réalisé au niveau de la deuxième extrémité 107 du guide d'onde 104, et plus particulièrement au niveau d'une partie de cette deuxième extrémité 107 dont la largeur est sensiblement constante et égale à celle au niveau de l'interface avec la première chambre 106. Ce contrôle de la divergence verticale du faisceau lumineux est également réalisé grâce à une couche réflectrice inférieure 120 disposée sous la deuxième extrémité 107 et s'étendant jusqu'au niveau de la face d'entrée de la première chambre 106, et grâce à une couche réflectrice supérieure 122 disposée au niveau de la paroi supérieure de la chambre 106. Le réseau de diffraction 118 comporte une série de rainures, ou fentes, parallèles réalisées dans la couche de coeur du guide d'onde 104 (qui est par exemple à base de germanium), les rainures étant remplies par un matériau dont l'indice de réfraction est inférieur à celui du matériau de la couche de coeur, par exemple par du SiO$_2$, du nitrure de silicium, etc. Le réseau de diffraction 118 est par exemple réalisé sur une longueur d'environ 1 mm pour obtenir une efficacité de découplage suffisante de l'ordre de 60%.

La figure 3 représente la deuxième extrémité 107 du guide d'onde 104 formé par une première couche 124 de silicium, sur laquelle est disposée une couche de coeur 126, par exemple en germanium, elle-même recouverte par une deuxième couche 128 de silicium, les couches 124 et 128 formant les couches de gainage inférieure et supérieure du guide d'onde 104. En variante, la couche de coeur 126 pourrait être en silicium, et les couches 124 et 128 en SiN. Le réseau de diffraction 118 est réalisé de préférence au niveau de la partie basse de la couche de coeur 126 qui se trouve en contact avec la couche de gainage inférieure 124 afin d'éviter, lors de la réalisation du réseau de diffraction 118, la mise en oeuvre d'une reprise d'épitaxie du matériau de coeur sur une couche de silicium non plane. Toutefois, il est possible que le réseau de diffraction 118 soit réalisé au niveau de la partie haute de la couche de coeur 126 qui se trouve en contact avec la couche de gainage supérieure 128. Dans la configuration représentée sur la figure 3, un ou plusieurs détecteurs acoustiques (non représentés sur cette figure) sont couplés à la première chambre 106, au niveau de la paroi inférieure de la chambre 106, et à la deuxième chambre 108.

Une première partie 130 des rayons lumineux diffractés par le réseau de diffraction 118 sont orientés vers le bas, c'est-à-dire vers la couche réflectrice inférieure 120, et une deuxième partie 132 des rayons lumineux diffractés par le réseau de diffraction 118 sont orientés vers le haut, c'est-à-dire vers la couche réflectrice supérieure 122. Le pas du réseau de diffraction 118 est calculé pour que l'angle de diffraction des rayons 130 et 132 (cet angle étant le même pour les rayons 130 et 132) soit tel que les rayons 130 orientés vers le bas ou les rayons 132 orientés vers le haut traversent toute la longueur de la première chambre 106, qui est par exemple d'environ 2,6 mm, afin de maximiser la longueur du trajet du rayonnement lumineux dans la première chambre 106. Sur l'exemple représenté sur la figure 3, cet angle de diffraction est tel que les rayons 130, qui se réfléchissent tout d'abord sur la couche réflectrice inférieure 120, traversent toute la longueur de la première chambre 106, cette traversée de la première chambre 106 étant réalisée avec une réflexion sur la couche réflectrice supérieure 122 afin de maximiser la longueur de trajet dans la première chambre 106. En variante, le réseau de diffraction 118 pourrait être tel que l'angle de diffraction formé par les rayons diffractés par le réseau 118 permet aux rayons 132 de traverser toute la longueur de la première chambre 106.

Grâce à l'élargissement de la deuxième extrémité 107 du guide d'onde 104 et à la présence du réseau de diffraction 118 et des couches réflectrices 120 et 122, un confinement des rayons lumineux dans la première chambre 106 est obtenu, améliorant ainsi le couplage lumière-gaz dans la première chambre 106 et évitant également que la deuxième chambre 108 soit partiellement illuminée à cause de la divergence du faisceau.

Un exemple de dimensionnement optique des éléments du dispositif 100 est décrit ci-dessous. Cet exemple est calculé pour une première chambre 106 destinée à recevoir les rayons lumineux qui est de forme rectangulaire et qui comporte une largeur et une hauteur chacune égale à environ 300 $\mu$m, et une longueur égale à environ 2,6 mm. En considérant l'exemple précédemment décrit en liaison avec la figure 3 dans lequel le trajet des rayons 130 (c'est-à-dire les rayons diffractés vers la couche réflectrice inférieure 120 puis vers la couche réflectrice supérieure 122) est maximisé, la valeur de l'angle de diffraction $\alpha$ souhaité avec lequel les rayons lumineux sont diffractés par le réseau de diffraction 118 est tout d'abord calculée de telle façon que ces rayons traversent toute la longueur de la chambre 106. La valeur de l'angle de diffraction $\alpha$ (angle mesuré par rapport à l'axe du guide d'onde 104) est calculée à partir de l'équation transcendante suivante :

$$sin(\alpha) = \frac{n_2}{n_1} sin\left[ a\,tan\left( \frac{2H - h_0 - d\,tan(\alpha)}{d} \right) \right] \qquad (1)$$

avec $n_2$ correspondant à l'indice de réfraction dans la chambre 106, c'est-à-dire ici égal à environ 1,
$n_1$ correspondant à l'indice de réfraction du matériau de la première couche 124 dans laquelle les rayons sont diffractés, et égale à environ 3,4 dans le cas d'une première couche 124 en silicium,
H la hauteur de la chambre 106, ici égale à 300 $\mu$m,
$h_0$ l'épaisseur de la première couche 124, ici égale à environ 10 $\mu$m,
d la distance entre le centre du réseau de diffraction 118 et la face d'entrée de la chambre 106, c'est-à-dire la moitié de la longueur du réseau de diffraction 18, ici égale à environ 0,5 mm.

L'angle de diffraction formé par les autres rayons (les rayons 132 dans l'exemple de la figure 3) sera similaire à celui pour les rayons dont le trajet est maximisé dans la première chambre 106. Il convient toutefois d'avoir un angle de diffraction suffisamment faible pour que ces autres rayons se dirigent tout de même vers la face d'entrée de la chambre 106.

Le pas $\Lambda$ du réseau de diffraction 118 est alors calculé selon l'équation suivante :

$$\Lambda = \frac{m\lambda}{n_{eff} - n_{Si}\,cos\,\alpha} \qquad (2)$$

avec m correspondant à l'ordre de diffraction et qui est égal à 1 pour le calcul du pas du réseau,
$\lambda$ correspondant à la longueur d'onde émise par la source lumineuse 102,
$n_{si}$ correspondant à l'indice de réfraction du silicium (plus généralement du matériau de la couche inférieure 124),
$\alpha$ correspondant à l'angle de diffraction,
$n_{eff}$ correspondant à l'indice effectif, c'est-à-dire l'indice vu par le mode (à la vitesse de propagation du mode dans le guide).

La source lumineuse 102 émet un rayonnement laser dans le domaine MIR à une longueur d'onde λ égale à 4 μm. Pour un angle de diffraction égal à 3,7° dans le silicium et égal à 12,5 ° dans l'air, un pas de 39 μm est obtenu pour α = 4°, nsi = 3,4 et $n_{eff}$ = 3,5. Lorsque ce réseau de diffraction 118 est réalisé sur une longueur d'environ 1 mm sur un guide d'onde 104 dont la largeur passe de 3 μm à 30 μm sur une longueur d'environ 300 μm, une absorption d'environ 11,1 mW par W incident (puissance du faisceau entrant dans la chambre) dans le $CO_2$ contenu dans l'air ambiant est obtenu, alors qu'une absorption de 4,6 mW par W incident est obtenue sans ces éléments permettant le confinement du faisceau lumineux. Un facteur d'environ 2,5 est obtenu sur la proportion de signal transmis dans la première chambre 106 grâce aux moyens de confinement utilisés. De plus, l'élargissement de la deuxième extrémité 107 du guide d'onde 104 a comme autre effet de réduire la diaphonie du fait que la deuxième chambre 108 n'est pas ou peu illuminée par le faisceau lumineux envoyé dans la première chambre 106.

Le taux de remplissage des rainures dans le réseau de diffraction 118 intervient sur le découplage réalisé. Il est déterminé par simulation et est par exemple égal à environ 50 %.

Selon une variante de réalisation, le dispositif 100 peut comporter des chambres 106 et 108 ne présentant pas des dimensions similaires. En effet, étant donné que le dispositif 100 est un dispositif miniaturisé réalisé via la mise en oeuvre de techniques de la microélectronique et des systèmes MEMS/NEMS, il peut apparaitre une opposition de phases entre les signaux de pression mesurés dans les deux chambres 106 et 108 qui soit imparfaite lorsque les dimensions des chambres 106 et 108 sont identiques. La soustraction de ces deux signaux qui est réalisée pour obtenir la mesure souhaitée n'est alors pas optimale. Afin d'améliorer cette opposition de phases, il est possible que les largeurs et/ou les longueurs des chambres 106 et 108 soit différentes l'une par rapport à l'autre. Une optimisation par simulation (par exemple en résolvant l'équation du champ de pression dans le dispositif 100, avec des chambres 106 et 108 de tailles différentes), par exemple via un calcul par la méthode des éléments finis, conduit au rapport optimal des dimensions des chambres 106 et 108.

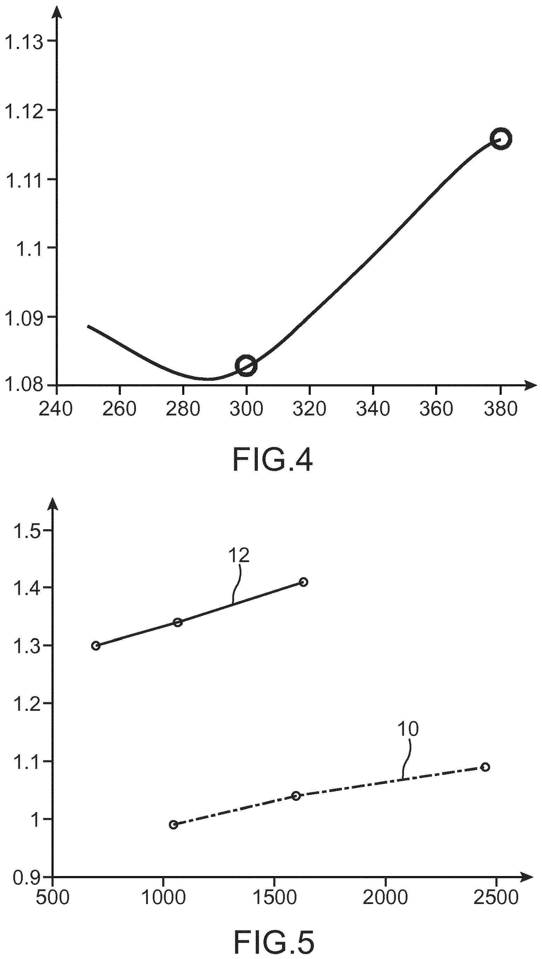

La courbe représentée sur la figure 4 correspond à l'amplitude du signal obtenu (en Pa, et correspondant à la différence des pressions mesurées par les détecteurs acoustiques dans les deux chambres 106 et 108) en fonction de la largeur de la deuxième chambre 108 (en μm), pour une première chambre 106 de largeur égale à environ 300 μm. On voit sur cette figure que l'amplitude maximale du signal n'est pas obtenue pour une deuxième chambre 108 ayant une largeur similaire à celle de la première chambre 106, c'est-à-dire égale à environ 300 μm, mais pour une largeur supérieure à 300 μm dans ce cas particulier. Dans d'autres cas, l'amplitude maximale du signal peut être obtenue pour une deuxième chambre 108 ayant une largeur inférieure à celle de la première chambre 106.

Le dispositif 100 est par exemple formé par l'assemblage de trois substrats :

- un premier substrat inférieur comportant les détecteurs acoustiques destinés à être couplés aux chambres 106 et 108, et dans lequel sont réalisés les canaux d'entrée et de sortie 114 et 116,
- un deuxième substrat milieu dans lequel sont formés la source lumineuse 102, le guide d'onde 104, le réseau de diffraction 118 et les chambres 106 et 108 ;
- un troisième substrat supérieur formant le capot des chambres 106 et 108 et dans lequel sont également réalisés les capillaires 110 et 112.

En variante, le dispositif 100 peut être réalisé avec seulement deux substrats. Dans ce cas, les capillaires 114 et 116 sont réalisés dans le deuxième substrat dans lequel les chambres 106 et 108 sont réalisées. Les capillaires 114 et 116 peuvent dans ce cas avoir une hauteur similaire à celle des chambres 106 et 108. En ne faisant appel qu'à deux substrats au lieu de trois, il est possible de réduire l'épaisseur des chambres 106 et 108 à une valeur inférieure à environ 300 μm du fait qu'une telle configuration avec deux substrats évite l'utilisation d'un substrat milieu dont l'épaisseur doit correspondre à l'épaisseur des chambres et qui est difficilement manipulable lorsque cette épaisseur est inférieure à environ 300 μm. En gravant les capillaires et les chambres dans un même substrat avec une profondeur qui est inférieure à l'épaisseur totale du substrat (du fait que dans ce cas, les parois supérieures des chambres et des capillaires sont formées par une partie non gravée du deuxième substrat et non par un troisième substrat reporté sur le deuxième substrat milieu), il est possible d'avoir des chambres 106 et 108 dont la hauteur est faible tout en conservant une épaisseur totale plus importante pour le substrat permettant une manipulation du substrat sans risque de casse. Un dispositif 100 réalisé avec seulement deux substrats permet la réalisation de chambres 106 et 108 dont l'épaisseur est par exemple comprise entre environ 300 μm et 100 μm, mais reste compatible avec la réalisation de chambres 106 et 108 d'épaisseur supérieure à environ 300 μm.

Cette réduction de l'épaisseur des chambres 106 et 108 permet d'obtenir un signal de sortie de plus forte amplitude. La courbe 10 représentée sur la figure 5 correspond à l'amplitude du signal obtenu (en Pa, et correspondant à la différence des pressions mesurées par les détecteurs acoustiques dans les deux chambres 106 et 108) en fonction de la distance entre les capillaires 110 et 112 pour un dispositif 100 dont les chambres 106 et 108 ont une épaisseur égale à environ 300 μm, et la courbe 12 correspond à l'amplitude du signal obtenu pour un dispositif 100 dont les chambres 106 et 108 ont une épaisseur égale à environ 200 μm. La figure 5 illustre bien le fait que l'amplitude du signal représenté par la courbe 12 est supérieure à celle obtenue pour le signal représenté par la courbe 10. De plus, l'amplitude du signal de sortie est impactée par la distance entre les capillaires 110 et 112 en raison des pertes d'énergie dans les couches limites et de la forme particulière de l'écoulement du gaz.

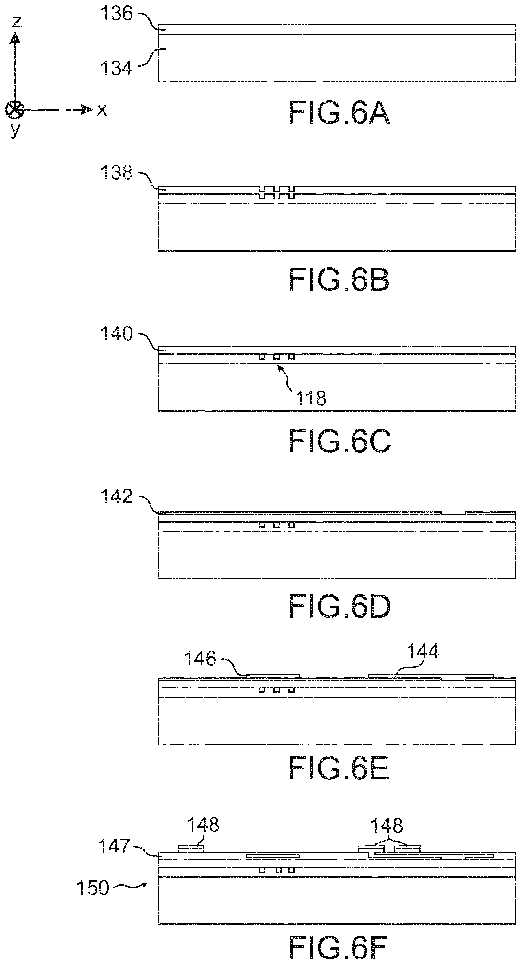

Un exemple de procédé de réalisation du dispositif de détection photoacoustique 100 est décrit en liaison avec les figures 6A à 6I qui représentent des vues en coupe schématiques des éléments du dispositif 100. Dans cet exemple de réalisation, le dispositif 100 est réalisé via un assemblage de trois substrats.

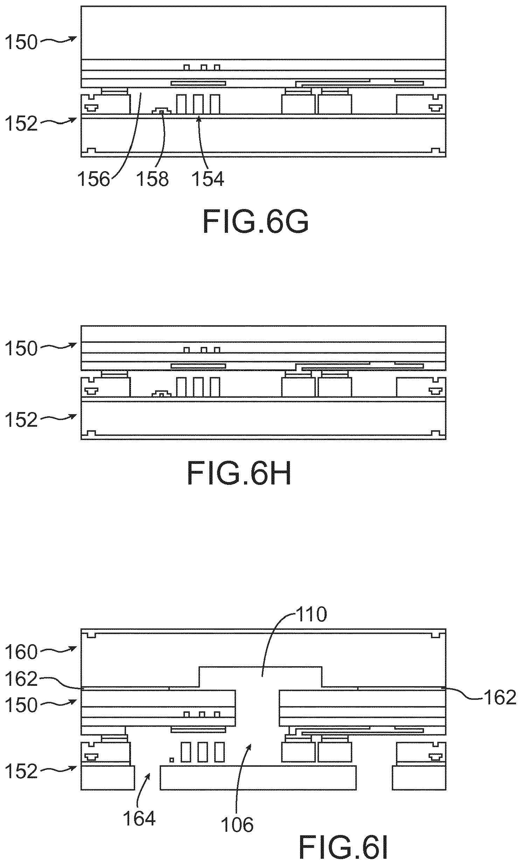

Les figures 6A à 6F représentent les étapes concernant la réalisation du deuxième substrat milieu qui comporte le guide d'onde 104, le réseau de diffraction 118 et les chambres 106 et 108, ainsi que d'autres éléments tels que les contacts électriques des détecteurs acoustiques. Les figures 6G à 6I représentent les étapes ultérieures du procédé au cours desquelles le deuxième substrat milieu est solidarisé au premier substrat inférieur et au troisième substrat supérieur formant notamment le capot des chambres 106 et 108.

Comme représenté sur la figure 6A, le deuxième substrat milieu correspond à un substrat 134 massif (« bulk ») de semi-conducteur, ici à base de silicium. Le matériau se trouvant au niveau d'une face supérieure du substrat 134 correspond au matériau qui formera la couche de gainage supérieure 128 du guide d'onde 104. On réalise ensuite un premier dépôt ou une croissance épitaxiale d'une couche 136 à base d'un matériau d'indice de réfraction supérieur à celui du matériau du substrat 134 et transparent à la ou aux longueurs d'ondes destinées à être transmises par le guide d'onde 104, ici un matériau transparent dans l'infrarouge et pour des longueurs d'ondes comprises entre environ 3 $\mu$m et 10 $\mu$m. Une partie de cette couche 136, par exemple formée par épitaxie, est destinée à former la couche de coeur 126 du guide d'onde 104. L'épaisseur et le matériau de la couche 136 sont choisis pour que le guide d'onde 104 puisse réaliser un guidage monomode du faisceau lumineux.

L'épaisseur de la couche 136 est par exemple comprise entre environ 1 et 10 $\mu$m, et est par exemple à base de germanium ou de SiGe selon le matériau souhaité pour former la couche de coeur 126 du guide d'onde 104. Dans le cas d'une couche 136 à base de SiGe, la composition en germanium du SiGe, c'est-à-dire la proportion de germanium dans le SiGe, peut être constante ou bien varier le long de l'épaisseur de la couche 136 pour réaliser une couche de coeur comprenant un gradient d'indice selon un profil (dans le sens de l'épaisseur de la couche 136) pouvant être triangulaire ou trapézoïdal. Par exemple, pour un guide d'onde 104 destiné à transmettre une longueur d'onde de 4,5 $\mu$m, la composition en germanium au sein de la couche 136 peut former, le long de l'épaisseur de cette couche, un profil triangulaire sur une épaisseur d'environ 3 $\mu$m avec une composition de germanium allant de 0% (au niveau des faces supérieure et inférieure de la couche 136) à 40 % au milieu de la couche 136, ces variations étant par exemple linéaires le long de l'épaisseur de la couche 136. En variante, la couche 136 peut être à base de SiGe et comporter une concentration en germanium constante le long de l'épaisseur de cette couche et par exemple égale à 40 %, la couche 136 ayant dans ce cas une épaisseur par exemple égale à 2,7 $\mu$m.

Le réseau de diffraction 118 est ensuite réalisé au niveau de la face supérieure de la couche 136. Pour cela, une lithographie et une gravure de type RIE (gravure ionique réactive) ou DRIE (gravure ionique réactive profonde) sont mises en oeuvre à l'emplacement prévu du réseau de diffraction 118, c'est-à-dire au niveau de la partie de la deuxième extrémité 107 du guide d'onde 104 qui est destinée à se trouver à proximité de l'emplacement prévu pour la première chambre 106 qui est destinée à recevoir le faisceau lumineux. La photolithographie et la gravure sont mises en oeuvre telles qu'elles forment, dans une partie de l'épaisseur de la couche 136 (l'épaisseur de la couche 136 étant par exemple comprise entre environ 1 $\mu$m et 10 $\mu$m), les rainures du réseau de diffraction dont les dimensions et l'espacement correspondent aux valeurs calculées afin d'obtenir l'angle de diffraction désiré, comme précédemment décrit.

Après cette gravure, une couche 138 de matériau dont l'indice de réfraction est inférieur à celui du matériau de la couche 136, tel que du SiO$_2$, du SiN ou du Si$_3$N$_4$, est formée, par exemple par dépôt, sur la couche 136 et dans les motifs gravés à travers la face supérieure de la couche 136 pour former le réseau de diffraction 118 (figure 6B).

La couche 138 est ensuite planarisée, par exemple via une planarisation mécano-chimique (CMP) avec arrêt sur la face supérieure de la couche 136, afin que le matériau de faible indice ne soit conservé que dans les motifs du réseau de diffraction 118.

Le coeur du guide d'onde 104 est ensuite réalisé par lithographie et gravure de la couche 136 afin qu'au moins une partie des portions restantes de la couche 136 forment la couche de coeur 126 du guide d'onde 104. Cette gravure n'est pas visible sur les figures 6A-6I. Cette gravure est réalisée à travers une partie ou la totalité de l'épaisseur de la couche 136 selon la structure souhaitée pour former le coeur du guide d'onde 104. Lorsque le guide d'onde 104 comporte une couche de coeur 126 en SiGe à gradient d'indice de forme triangulaire, la couche 136 peut être gravée telle que la portion restante formant le guide d'onde 104 ait une largeur égale à environ 3,3 $\mu$m, ou comprise entre environ 3,3 $\mu$m et 8 $\mu$m, ce qui lui permet de réaliser un guidage monomode d'un faisceau lumineux de longueur d'onde égale à 4,5 $\mu$m. Comme précédemment décrit, la deuxième extrémité 107 du guide d'onde 104 est réalisée avec un élargissement progressif afin de permettre une transmission du mode fondamental du faisceau lumineux pour lequel le réseau de diffraction 118 est optimisé tout en réduisant la diffraction du faisceau selon la direction de l'élargissement, et donc améliorer le confinement horizontal du faisceau lumineux.

La ou les portions restantes de la couche 136 sont ensuite recouvertes par le dépôt ou la croissance épitaxiale d'une couche 140 destinée à former la couche de gainage inférieure 124 du guide d'onde 104, qui est donc à base d'un matériau de plus faible indice de réfraction que celui de la couche de coeur, et par exemple à base de silicium dans le cas d'une couche de coeur en SiGe. Cette couche 140 est ensuite planarisée par exemple via une CMP afin que la face supérieure de la couche 104 forme une surface plane (figure 6C).

En variante, la réalisation du réseau de diffraction 118 pourrait être simplifiée en mettant en oeuvre une seule étape de lithographie, une seule étape de gravure et une seule étape de CMP.

Des matériaux autres que le silicium et le germanium peuvent être utilisés pour réaliser le guide d'onde 104, ces matériaux devant toutefois permettre une transmission de la longueur d'onde du faisceau lumineux et être compatibles avec les techniques mises en oeuvre pour réaliser le dispositif 100. Il est toutefois possible de réaliser le guide d'onde 104 avec une couche de coeur en silicium et disposée entre deux couches de gainage en SiN.

Une couche diélectrique 142 est ensuite déposée sur la couche 140, par exemple à base de $SiO_2$ et d'épaisseur égale à environ 1 $\mu$m, ou à base de SiN ou d'$Al_2O_3$. Cette couche diélectrique 142 est gravée au niveau d'emplacements destinés à former des reprises de contact électriques des détecteurs acoustiques du dispositif 100 (figure 6D). Une couche électriquement conductrice, par exemple à base de métal, est ensuite déposée sur la couche diélectrique 142. Cette couche électriquement conductrice est par exemple à base d'AlSi (comportant environ 1 % de silicium). La couche électriquement conductrice est ensuite gravée afin que des portions restantes 144 de cette couche, remplissant notamment les emplacements précédemment gravés dans la couche diélectrique 142, forment les contacts électriques des détecteurs acoustiques. Au moins une autre portion restante 146 de cette couche électriquement conductrice peut également être conservée afin de former la couche réflectrice inférieure 120, notamment lorsque le matériau de la couche diélectrique 142 ne permet pas que cette fonction de réflexion de la lumière diffractée par le réseau de diffraction 118 ne soit remplie par la couche 142 (figure 6E). Dans le cas d'une couche 142 en $SiO_2$ et d'un coeur du guide d'onde 104 en germanium ou en SiGe entouré de couches de gainage en silicium, cette fonction de réflexion lumineuse est remplie par la couche 142 car une réflexion lumineuse totale se produit à l'interface $Si/SiO_2$ en raison du faible angle d'incidence du faisceau lumineux diffracté par le réseau de diffraction 118.

Une autre couche diélectrique 147, par exemple à base d'un matériau similaire à celui de la couche diélectrique 142, et/ou d'épaisseur similaire à celle de la couche diélectrique 142, est ensuite déposée en recouvrant les portions restantes 144, 146. Une couche de scellement est ensuite réalisée afin de permettre par la suite la solidarisation du deuxième substrat milieu avec le premier substrat comportant les détecteurs acoustiques. Cette couche de scellement peut correspondre soit à une couche métallique, par exemple une couche à base d'or et d'épaisseur égale à environ 800 nm, ou une couche à base d'aluminium d'épaisseur égale à environ 400 nm disposée sur une couche de germanium d'épaisseur égale à environ 200 nm, permettant de réaliser un scellement eutectique avec le semi-conducteur (par exemple du silicium) du premier substrat. Cette couche de scellement peut également correspondre à une couche de polymère par exemple d'épaisseur égale à environ 1 $\mu$m. Comme représenté sur la figure 6F, cette couche de scellement est gravée afin de ne conserver des portions de scellement 148 qu'à certains endroits. De plus, certaines des portions de scellement restantes sont reliées électriquement aux portions restantes conductrices 144 avec de former les contacts électriques qui seront reliés électriquement aux détecteurs acoustiques du dispositif 100.

Comme représenté sur la figure 6G, le deuxième substrat milieu 150 obtenu par la mise en oeuvre des étapes précédemment décrites est retourné et solidarisé au premier substrat, référencé 152, qui comporte les détecteurs acoustiques ainsi que d'autres éléments électriques et/ou électroniques non visibles sur les figures 6A-6I. Du fait du retournement du deuxième substrat milieu 150, le réseau de diffraction 118 se retrouve localisé dans la partie inférieure de la couche de coeur 126 du guide d'onde 104, comme précédemment décrit en liaison avec la figure 3. Les détecteurs acoustiques 154, qui sont des microphones piézorésistifs de type poutre, sont disposés à proximité de la partie du deuxième substrat 150 dans laquelle les chambres 106 et 108 sont destinées à être réalisées, et sont reliés électriquement aux contacts électriques 144 précédemment réalisés. De plus, les détecteurs 154 sont disposés dans une partie 156 gravée du premier substrat 152 qui permettra ultérieurement de réaliser une mise à l'air des détecteurs 154 afin qu'ils soient soumis à la pression atmosphérique. De plus, les détecteurs 154 sont reliés à des nanojauges de contrainte 158 permettant la transformation des pressions mesurées par les détecteurs acoustiques 154 en signaux électriques.

Après le scellement du deuxième substrat milieu 150 au premier substrat 152, le deuxième substrat milieu 150 peut être aminci à l'épaisseur souhaitée correspondant à la hauteur désirée des chambres 106 et 108, par exemple égale à 300 $\mu$m (figure 6H). Cet amincissement est réalisé en réduisant l'épaisseur de la couche massive 134.

Des étapes de lithographie et gravure (par exemple de type DRIE) sont ensuite réalisées à travers le second substrat milieu 150 pour former les chambres 106 et 108.

La lumière de la source lumineuse 102 laser peut être injectée directement dans le guide d'onde 104, la source lumineuse 102 étant dans ce cas couplée bout-à-bout avec le guide d'onde 104 via un couplage dit « hybride ». Il est également possible d'avoir un couplage « hétérogène » dans lequel la source lumineuse 102 laser, par exemple de type QCL et réalisé en matériau III-V, est rapporté sur le substrat de silicium. Une structure supplémentaire, formée par exemple par lithographie et gravure, assure dans ce cas le couplage entre le guide d'onde 104 et la source lumineuse 102. Les couches épitaxiées du laser QCL peuvent être transférées sur le silicium par collage direct, comme décrit par exemple dans le document « Electrically driven hybrid Si/III-V Fabry-Pérot lasers based on adiabatic mode transformers » de B. Ban Bakir et al., Opt. Express 2011, vol. 19, n°11, 23 mai 2011.

Comme représenté sur la figure 6I, le troisième substrat supérieur 160 est solidarisé sur le deuxième substrat milieu 150 aminci. Les capillaires 110 et 112 sont réalisés dans le troisième substrat supérieur 160 préalablement à la solidarisation de ce troisième substrat 160 avec le deuxième substrat milieu 150. La solidarisation est mise en oeuvre via une couche de scellement eutectique, par exemple formée d'un empilement d'une couche de tungstène d'épaisseur égale à 50 nm, d'une couche de nitrure de tungstène d'épaisseur égale à 50 nm et d'une couche d'or d'épaisseur égale à 800 nm, déposées puis structurées sous la forme d'un cordon de scellement 162. Le troisième substrat 160 forme notamment les parois supérieures des chambres 106 et 108. Ainsi, une des portions restantes de la couche de scellement peut être utilisée pour former la couche réflectrice supérieure 122 dans la première chambre 106. Le scellement eutectique est réalisé entre la couche d'or du cordon de scellement 162 et le silicium (correspondant au matériau de la couche 134 amincie) du deuxième substrat milieu 150.

En variante, préalablement à la solidarisation du troisième substrat 160 au deuxième substrat 150, les capillaires 110, 112 peuvent être réalisés après le dépôt et la structuration de la couche de scellement eutectique. Dans ce cas, la couche réflectrice supérieure 122 est déposée ultérieurement par exemple à travers un pochoir pour localiser cette couche au niveau de la partie du troisième substrat supérieure 160 destinée à forme la paroi supérieure de la première chambre 106.

Les canaux d'entrée 114 et de sortie 116 sont réalisés à travers le premier substrat inférieur 152. D'autres ouvertures 164 sont réalisées à travers le premier substrat inférieur 152 notamment pour que les détecteurs acoustiques 154 soient à la pression atmosphérique et former des accès pour graver des portions de matériau diélectriques temporaires présentes dans les substrats, en contact notamment avec les détecteurs acoustiques 154 et avec les portions métalliques 144, 146.

Dans le cas d'une réalisation du dispositif 100 avec uniquement deux substrats, les capillaires 110 et 112 sont réalisés dans la même couche que les chambres 106 et 108, c'est-à-dire dans le deuxième substrat 150. Dans ce cas, la couche réflectrice supérieure est réalisée via une étape de métallisation au pochoir au niveau de la paroi de fond de la cavité destinée à former la première chambre 106, préalablement à la solidarisation des deux substrats.

Dans le dispositif 100 précédemment décrit, le réseau de diffraction 118 est dimensionné notamment en fonction de la longueur d'onde du faisceau lumineux destiné à être diffracté, la longueur d'onde du faisceau lumineux étant adaptée en fonction de la nature du gaz à détecter. Le dispositif 100 peut être adapté pour réaliser une détection de plusieurs types de gaz en réalisant dans le dispositif 100 plusieurs guides d'ondes parallèles qui débouchent sur une ou sur deux faces d'entrée (de chaque côté) de la première chambre 106, chacun des guides d'onde étant couplé à une source lumineuse émettant à une longueur d'onde différente, par exemple entre 4 $\mu$m et 5 $\mu$m, qui est destinée à être diffractée par le réseau de diffraction réalisé sur chacun des guides d'ondes. Un multiplexeur optique peut également être utilisé pour que la chambre 106 puisse recevoir différentes longueurs d'ondes, comme décrit dans le document EP 2 515 096 A1. En outre, il est également possible que les deux chambres 106 et 108 soient couplées à des sources lumineuses émettant par exemple à des longueurs d'ondes différentes les unes des autres, ce qui permet d'exciter le gaz présent dans l'une ou l'autre des chambres 106 et 108 selon le gaz à détecter.

Dans le dispositif 100 précédemment décrit, le confinement horizontal du faisceau lumineux est réalisé grâce à l'élargissement de la deuxième extrémité 107 du guide d'onde 104. Ce confinement horizontal peut être amélioré en réalisant des tranchées remplies d'un matériau réflecteur, par exemple un métal tel que de l'or, de l'aluminium, autour de la première chambre 106. Ces tranchées sont suffisamment éloignées, par exemple de quelques dizaines de microns, de la première chambre 106 pour ne pas ajouter de bruit de fond thermique, lié à l'absorption du rayonnement infrarouge par les matériaux environnant la chambre excitée. De telles tranchées peuvent être réalisées dans le deuxième substrat 150, par exemple lors de la gravure des chambres 106 et 108.

Dans l'exemple de la figure 1 précédemment décrit, les canaux d'entrée 114 et de sortie 116 sont reliés aux capillaires 110 et 112 sensiblement au niveau du milieu de ces capillaires 110, 112. En variante, étant donné que le dispositif 100 est un dispositif miniaturisé réalisé par la mise en oeuvre d'étapes de la microélectronique, ces canaux d'entrée 114 et de sortie 116 peuvent être reliés aux capillaires 110 et 112 à un autre niveau que leur milieu, et cela sans perturber la symétrie de l'écoulement du gaz dans le dispositif 100.

Pour augmenter l'intensité du signal mesuré par les détecteurs acoustiques du dispositif 100, il est possible de placer les capillaires 110, 112 aux extrémités des chambres 106, 108. Une telle configuration permet d'augmenter d'environ 5 % l'amplitude du signal mesuré par les détecteurs acoustiques.

Les différentes options de réalisation décrites dans le document EP 2 515 096 A1, comme par exemple l'utilisation d'un refroidisseur à effet Peltier, d'un amplificateur intégré au dispositif de détection photoacoustique, ou les différents exemples de matériaux décrits, peuvent s'appliquer au dispositif de détection photoacoustique de l'invention.

**Revendications**

1. Dispositif microélectronique de détection photoacoustique (100) comprenant :

   - au moins un substrat (150, 160) comportant des cavités (106, 108, 110, 112) formant un résonateur acoustique différentiel de type Helmholtz ;
   - des détecteurs acoustiques (154) couplés à deux desdites cavités formant des chambres (106, 108) du résonateur ;
   - une source lumineuse (102) apte à émettre un faisceau lumineux (130, 132) à au moins une longueur d'onde donnée ;
   - un guide d'onde optique (104) comportant une première extrémité (105) couplée optiquement à la source lumineuse (102) et une deuxième extrémité (107) couplée optiquement à une première (106) des deux chambres,

   **caractérisé en ce que** la deuxième extrémité (107) comporte, au niveau d'une interface avec la première chambre (106), une largeur de valeur supérieure à celle de la largeur de la première extrémité (105) et supérieure à celle de ladite au moins une longueur d'onde donnée, la largeur étant une dimension sensiblement perpendiculaire à une direction de propagation du faisceau lumineux (130, 132) dans le guide d'onde optique (104), et/ou dans lequel le dispositif de détection photoacoustique (100) comporte au moins un réseau de diffraction (118) disposé dans la deuxième extrémité (107) du guide d'onde (104) et apte à diffracter une première partie (130) du faisceau lumineux vers une couche réflectrice inférieure (120) du guide d'onde optique (104) disposée sous la deuxième extrémité (107) et une deuxième partie (132) du faisceau lumineux vers une couche réflectrice supérieure (122) formant une paroi supérieure de la première chambre (106).

2. Dispositif (100) selon la revendication 1, dans lequel un rapport entre la largeur de la deuxième extrémité (107) au niveau de l'interface avec la première chambre (106) et la largeur de la première extrémité (105) est supérieur ou égal à 3.

3. Dispositif (100) selon l'une des revendications précédentes, dans lequel la deuxième extrémité (107) forme une portion du guide d'onde (104) dont la largeur croit depuis une première valeur égale à celle de la largeur de la première extrémité (105) jusqu'à une deuxième valeur égale à celle de la largeur de la deuxième extrémité (107) au niveau de l'interface avec la première chambre (106).

4. Dispositif (100) selon la revendication 3, dans lequel la largeur de la deuxième extrémité (107) croit sur une partie, appelée première partie, de la deuxième extrémité (107) dont la longueur est supérieure ou égale à environ dix fois la largeur de la deuxième extrémité (107) au niveau de l'interface avec la première chambre (106).

5. Dispositif (100) selon l'une des revendications précédentes, dans lequel le réseau de diffraction (118) est disposé dans une partie, appelée deuxième partie, de la deuxième extrémité (107) dont la largeur est sensiblement constante et égale à celle au niveau de l'interface avec la première chambre (106).

6. Dispositif (100) selon l'une des revendications précédentes, dans lequel le réseau de diffraction (118) est disposé au niveau d'une interface entre une couche de coeur (126) du guide d'onde (104) et une couche de gainage inférieure (124) du guide d'onde (104), la couche de gainage inférieure (124) étant disposée entre la couche de coeur (126) et la couche réflectrice inférieure (120).

7. Dispositif (100) selon l'une des revendications précédentes, dans lequel le réseau de diffraction (118) est apte à diffracter le faisceau lumineux tel que la première (130) ou la deuxième (132) partie du faisceau lumineux atteigne, après une réflexion sur la couche réflectrice inférieure (120) et/ou la couche réflectrice supérieure (122), une paroi de fond de la première chambre (106) qui est opposée à celle en contact avec la deuxième extrémité (107) du guide d'onde (104).

8. Dispositif (100) selon l'une des revendications précédentes, dans lequel les détecteurs acoustiques (154) sont disposés dans un premier substrat (152) et couplés aux chambres (106, 108) du résonateur formées dans un deuxième substrat (150) solidarisé au premier substrat (152), des volumes des chambres (106, 108) communiquant entre eux par des capillaires (110, 112) formés dans un troisième substrat (160) solidarisé au deuxième substrat (150).

9. Dispositif (100) selon l'une des revendications 1 à 7, dans lequel les détecteur acoustiques (154) sont disposés dans un premier substrat (152) et couplés aux chambres (106, 108) du résonateur formées dans un deuxième substrat (150) solidarisé au premier substrat (152), des volumes des chambres (106, 108) communiquant entre eux par des capillaires (110, 112) formés dans le deuxième substrat (150), le deuxième substrat (150) ayant une épaisseur inférieure à 300 μm.

10. Dispositif (100) selon l'une des revendications précédentes, comportant en outre des tranchées remplies d'au moins un matériau optiquement réfléchissant et disposées autour des parois latérales de la première chambre (106).

11. Dispositif (100) selon l'une des revendications précédentes, dans lequel les deux chambres (106, 108) comportent des dimensions différentes l'une par rapport à l'autre.

12. Dispositif (100) selon l'une des revendications précédentes, dans lequel les détecteurs acoustiques (154) comportent des microphones piézorésistifs de type poutre.

13. Dispositif de détection de gaz, comportant au moins un dispositif microélectronique de détection photoacoustique (100) selon l'une des revendications précédentes et comportant en outre des canaux d'entrée (114) et de sortie (116) de gaz communiquant avec les chambres (106, 108) du résonateur et dans lequel la longueur d'onde destinée à être émise par la source lumineuse (102) correspond à une longueur d'onde d'absorption d'un gaz destiné à être détecté.

14. Procédé de réalisation d'un dispositif microélectronique de détection photoacoustique (100), comportant au moins les étapes de :

    - réalisation, dans au moins un substrat (150, 160), d'un guide d'onde optique (104) comportant une première extrémité (105) et une deuxième extrémité (107),
    - réalisation d'une source lumineuse (102) apte à émettre un faisceau lumineux à au moins une longueur d'onde donnée et telle que la source lumineuse (102) soit couplée optiquement à la première extrémité (105) du guide d'onde (104),
    - réalisation, dans ledit au moins un substrat (150, 160), de cavités (106, 108, 110, 112) formant un résonateur acoustique différentiel de type Helmholtz, deux desdites cavités formant des chambres (106, 108) du résonateur telles qu'une première (106) des deux chambres soit couplée optiquement avec la deuxième extrémité (107) du guide d'onde (104),
    - couplage de détecteurs acoustiques (154) avec les chambres (106, 108) du résonateur,

**caractérisé en ce que** la deuxième extrémité (107) comporte, au niveau d'une interface avec la première chambre (106), une largeur de valeur supérieure à celle de la largeur de la première extrémité (105) et supérieure à celle de ladite au moins une longueur d'onde donnée, la largeur étant une dimension sensiblement perpendiculaire à une direction de propagation du faisceau lumineux (130, 132) dans le guide d'onde optique (104), et/ou dans lequel le procédé comporte la réalisation d'au moins un réseau de diffraction (118) dans la deuxième extrémité (107) du guide d'onde (104) apte à diffracter une première partie (130) du faisceau lumineux vers une couche réflectrice inférieure (120) du guide d'onde optique (104) disposée sous la deuxième extrémité (107) et une deuxième partie (132) du faisceau lumineux vers une couche réflectrice supérieure (122) formant une paroi supérieure de la première chambre (106).

**Patentansprüche**

1. Mikroelektronische Vorrichtung zur fotoakustischen Detektion (100), umfassend:

    - wenigstens ein Substrat (150, 160), umfassend Hohlräume (106, 108, 110, 112), welche einen differentiellen akustischen Resonator vom Helmholtz-Typ bilden;
    - akustische Detektoren (154), welche mit zwei der Hohlräume gekoppelt sind, welche Kammern (106, 108) des Resonators bilden;
    - eine Lichtquelle (102), welche in der Lage ist, einen Lichtstrahl (130, 132) mit wenigstens einer gegebenen Wellenlänge zu emittieren;
    - einen optischen Wellenleiter (104), welcher ein erstes Ende (105), welches optisch mit der Lichtquelle (102) gekoppelt ist, und ein zweites Ende (107) umfasst, welches optisch mit einer ersten (106) der beiden Kammern gekoppelt ist,

**dadurch gekennzeichnet, dass** das zweite Ende (107) auf dem Niveau einer Schnittstelle mit der zweiten Kammer (106) eine Größe mit einem größeren Wert umfasst als derjenige der Größe des ersten Endes (105) und größer als derjenige der wenigstens einen gegebenen Wellenlänge, wobei die Größe eine Abmessung im Wesentlichen senkrecht zu einer Ausbreitungsrichtung des Lichtstrahls (130, 132) in dem optischen Wellenleiter (104) ist und/oder wobei die Vorrichtung zur fotoakustischen Detektion (100) wenigstes ein Diffraktionsgitter (118) umfasst, welches an dem zweiten Ende (107) des Wellenleiters (104) angeordnet und dazu in der Lage ist, einen ersten Teil (130) des Lichtstrahls in Richtung einer unteren reflektiven Schicht (120) des optischen Wellenleiters (104), welche unter dem zweiten Ende (107) angeordnet ist, sowie einen zweiten Teil (132) des Lichtstrahls in Richtung einer oberen reflektiven Schicht (122) abzulenken, welche eine obere Wand der ersten Kammer (106) bildet.

2. Vorrichtung (100) nach Anspruch 1, wobei ein Verhältnis zwischen der Größe des zweiten Endes (107) auf dem Niveau der Schnittstelle mit der ersten Kammer (106) und der Größe des ersten Endes (105) größer oder gleich 3 ist.

3. Vorrichtung (100) nach einem der vorhergehenden Ansprüche, wobei das zweite Ende (107) einen Teil des Wellenleiters (104) bildet, dessen Größe von einem ersten Wert gleich demjenigen der Größe des ersten Endes (105) bis zu einem zweiten Wert gleich demjenigen der Größe des zweiten Endes (107) auf dem Niveau der Schnittstelle mit der ersten Kammer (106) zunimmt.

4. Vorrichtung (100) nach Anspruch 3, wobei die Größe des zweiten Endes (107) an einem als erster Teil bezeichneten Teil des zweiten Endes (107) zunimmt, dessen Länge größer oder gleich etwa zehnmal die Größe des zweiten Endes (107) auf dem Niveau der Schnittstelle mit der ersten Kammer (106) ist.

5. Vorrichtung (100) nach einem der vorhergehenden Ansprüche, wobei das Diffraktionsgitter (118) an einem als zweiter Teil bezeichneten Teil des zweiten Endes (107) angeordnet ist, dessen Größe im Wesentlichen konstant und gleich derjenigen auf dem Niveau der Schnittstelle mit der ersten Kammer (106) ist.

6. Vorrichtung (100) nach einem der vorhergehenden Ansprüche, wobei das Diffraktionsgitter (118) auf dem Niveau einer Schnittstelle zwischen einer Herzschicht (126) des Wellenleiters (104) und einer unteren Hüllschicht (124) des Wellenleiters (104) angeordnet ist, wobei die untere Hüllschicht (124) zwischen der Herzschicht (126) und der unteren reflektiven Schicht (120) angeordnet ist.

7. Vorrichtung (100) nach einem der vorhergehenden Ansprüche, wobei das Diffraktionsgitter (118) dazu in der Lage ist, den Lichtstrahl derart abzulenken, dass der erste (130) oder zweite (132) Teil des Lichtstrahls nach einer Reflexion an der unteren reflektiven Schicht (120) und/oder der oberen reflektiven Schicht (122) eine Bodenwand der ersten Kammer (106) erreicht, welche derjenigen in Kontakt mit dem zweiten Ende (107) des Wellenleiters (104) gegenüber liegt.

8. Vorrichtung (100) nach einem der vorhergehenden Ansprüche, wobei die akustischen Detektoren (154) an einem ersten Substrat (152) angeordnet und mit Kammern (106, 108) des Resonators gekoppelt sind, welche an einem zweiten Substrat (150) gebildet sind, welches mit dem ersten Substrat (152) verbunden ist, wobei Volumina der Kammern (106, 108) zwischen einander durch Kapillaren (110, 112) kommunizieren, welche an einem dritten Substrat (160) gebildet sind, welches mit dem zweiten Substrat (150) verbunden ist.

9. Vorrichtung (100) nach einem der Ansprüche 1 bis 7, wobei die akustischen Detektoren (154) an einem ersten Substrat (152) angeordnet und mit Kammern (106, 108) des Resonators gekoppelt sind, welche an einem zweiten Substrat (150) gebildet sind, welches mit dem ersten Substrat (152) verbunden ist, wobei Volumina der Kammern (106, 108) zwischen einander durch Kapillaren (110, 112) kommunizieren, welche an dem zweiten Substrat (150) gebildet sind, wobei das zweite Substrat (150) eine Dicke aufweist, welche geringer als 300 μm ist.

10. Vorrichtung (100) nach einem der vorhergehenden Ansprüche, ferner umfassend Gräben, welche mit wenigstens einem optisch reflektierenden Material gefüllt sind und um die lateralen Wände der ersten Kammer (106) herum angeordnet sind.

11. Vorrichtung (100) nach einem der vorhergehenden Ansprüche, wobei die beiden Kammern (106, 108) voneinander verschiedene Abmessungen aufweisen.

12. Vorrichtung (100) nach einem der vorhergehenden Ansprüche, wobei die akustischen Detektoren (154) piezoresistive Mikrofone vom Balkentyp umfassen.

**13.** Vorrichtung zur Detektion von Gas, umfassend wenigstens eine mikroelektronische Vorrichtung zur fotoakustischen Detektion (100) nach einem der vorhergehenden Ansprüche und ferner umfassend Eintritts- (114) und Austritts- (116) Kanäle für Gas in Kommunikation mit den Kammern (106, 108) des Resonators und wobei die Wellenlänge, welche vorgesehen ist, von der Lichtquelle (102) emittiert zu werden, einer Absorptions-Wellenlänge eines Gases entspricht, welches vorgesehen ist, detektiert zu werden.

**14.** Verfahren zum Herstellen einer mikroelektronischen Vorrichtung zur fotoakustischen Detektion (100), umfassend wenigstens die Schritte:

- Herstellen eines optischen Wellenleiters (104) an wenigstens einem Substrat (150, 160), welcher ein erstes Ende (105) und ein zweites Ende (107) umfasst,
- Herstellen einer Lichtquelle (102), welche in der Lage ist, einen Lichtstrahl bei wenigstens einer gegebenen Wellenlänge zu emittieren, derart, dass die Lichtquelle (102) optisch mit dem ersten Ende (105) des Wellenleiters (104) gekoppelt ist,
- Herstellen von Hohlräumen (106, 108, 110, 112) an dem wenigstens einen Substrat (150, 160), welche einen differentiellen akustischen Resonator vom Helmholtz-Typ bilden, wobei zwei der Hohlräume Kammern (106, 108) des Resonators derart bilden, dass eine erste (106) der beiden Kammern optisch mit dem zweiten Ende (107) des Wellenleiters (104) gekoppelt ist,
- Koppeln von akustischen Detektoren (154) mit den Kammern (106, 108) des Resonators,

**dadurch gekennzeichnet, dass** das zweite Ende (107) auf dem Niveau einer Schnittstelle mit der ersten Kammer (106) eine Größe mit einem größeren Wert umfasst als derjenige der Größe des ersten Endes (105) und größer als derjenige der wenigstens einen gegebenen Wellenlänge, wobei die Größe eine Abmessung im Wesentlichen senkrecht zu einer Ausbreitungsrichtung des Lichtstrahls (130, 132) in dem optischen Wellenleiter (104) ist und/oder wobei das Verfahren die Herstellung von wenigstens einem Diffraktionsgitter (118) an dem zweiten Ende (107) des Wellenleiters (104) umfasst, welches in der Lage ist, einen ersten Teil (130) des Lichtstrahls in Richtung einer unteren reflektiven Schicht (120) des optischen Wellenleiters (104), welche unter dem zweiten Ende (107) angeordnet ist, sowie einen zweiten Teil (132) des Lichtstrahls in Richtung einer oberen reflektiven Schicht (122) abzulenken, welche eine obere Wand der ersten Kammer (106) bildet.

**Claims**

**1.** A microelectronic photoacoustic detection device (100) comprising:

- at least one substrate (150, 160) comprising cavities (106, 108, 110, 112) forming a Helmholtz type differential acoustic resonator;
- acoustic detectors (154) coupled to two of said cavities forming chambers (106, 108) of the resonator;
- a light source (102) capable of emitting a light beam (130, 132) at at least one given wavelength;
- an optical waveguide (104) comprising a first end (105) optically coupled to the light source (102) and a second end (107) optically coupled to a first (106) of the two chambers,

**characterized in that** the second end (107) comprises, at an interface with the first chamber (106), a width of value greater than that of the width of the first end (105) and greater than that of said at least one given wavelength, the width being a dimension which is substantially perpendicular to a direction of propagation of the light beam (130, 132) in the optical waveguide (104), and/or in which the photoacoustic detection device (100) comprises at least one diffraction grating (118) arranged in the second end (107) of the waveguide (104) and capable of diffracting a first part (130) of the light beam towards a lower reflective layer (120) of the optical waveguide (132) arranged under the second end (107) and a second part (132) of the light beam towards an upper reflective layer (122) forming an upper wall of the first chamber (106).

**2.** Device (100) according to claim 1, in which a ratio between the width of the second end (107) at the interface with the first chamber (106) and the width of the first end (105) is greater than or equal to 3.

**3.** Device (100) according to one of previous claims, in which the second end (107) forms a portion of the waveguide (104) of which the width increases from a first value equal to that of the width of the first end (105) up to a second value equal to that of the width of the second end (107) at the interface with the first chamber (106).

4.  Device (100) according to claim 3, in which the width of the second end (107) increases on a part, called first part, of the second end (107) of which the length is greater than or equal to around ten times the width of the second end (107) at the interface with the first chamber (106).

5.  Device (100) according to one of previous claims, in which the diffraction grating (118) is arranged in a part, called second part, of the second end (107) of which the width is substantially constant and equal to that at the interface with the first chamber (106).

6.  Device (100) according to one of previous claims, in which the diffraction grating (118) is arranged at an interface between a core layer (126) of the waveguide (104) and a lower cladding layer (124) of the waveguide (104), the lower cladding layer (124) being arranged between the core layer (126) and the lower reflective layer (120).

7.  Device (100) according to one of previous claims, in which the diffraction grating (118) is capable of diffracting the light beam such that the first (130) or the second (132) part of the light beam reaches, after a reflection on the lower reflective layer (120) and/or the upper reflective layer (122), a bottom wall of the first chamber (106) which is opposite to that in contact with the second end (107) of the waveguide (104).

8.  Device (100) according to one of previous claims, in which the acoustic detectors (154) are arranged in a first substrate (152) and coupled to the chambers (106, 108) of the resonator formed in a second substrate (150) made integral with the first substrate (152), volumes of the chambers (106, 108) communicating together via capillaries (110, 112) formed in a third substrate (160) made integral with the second substrate (150).

9.  Device (100) according to one of claims 1 to 7, in which the acoustic detectors (154) are arranged in a first substrate (152) and coupled to the chambers (106, 108) of the resonator formed in a second substrate (150) made integral with the first substrate (152), volumes of the chambers (106, 108) communicating together via capillaries (110, 112) formed in the second substrate (150), the second substrate (150) having a thickness less than 300 $\mu$m.

10. Device (100) according to one of previous claims, further comprising trenches filled with at least one optically reflective material and arranged around lateral walls of the first chamber (106).

11. Device (100) according to one of previous claims, in which the two chambers (106, 108) comprise dimensions different to each other.

12. Device (100) according to one of previous claims, in which the acoustic detectors (154) comprise beam type piezoresistive microphones.

13. A gas detection device, comprising at least one microelectronic photoacoustic detection device (100) according to one of previous claims and further comprising gas inlet (114) and outlet (116) channels communicating with the chambers (106, 108) of the resonator and in which the wavelength intended to be emitted by the light source (102) corresponds to an absorption wavelength of a gas intended to be detected.

14. A method of producing a microelectronic photoacoustic detection device (100), comprising at least the steps of:

    - forming, in at least one substrate (150, 160), an optical waveguide (104) comprising a first end (105) and a second end (107),
    - forming a light source (102) capable of emitting a light beam at at least one given wavelength and such that the light source (102) is optically coupled to the first end (105) of the waveguide (104),
    - forming, in said at least one substrate (150, 160), cavities (106, 108, 110, 112) forming a Helmholtz type differential acoustic resonator, two of said cavities forming chambers (106, 108) of the resonator such that a first (106) of the two chambers is optically coupled with the second end (107) of the waveguide (104),
    - coupling of the acoustic detectors (154) with the chambers (106, 108) of the resonator,

    **characterized in that** the second end (107) comprises, at an interface with the first chamber (106), a width of value greater than that of the width of the first end (105) and greater than that of said at least one given wavelength, the width being a dimension which is substantially perpendicular to a direction of propagation of the light beam (130, 132) in the optical waveguide (104), and/or in which the method comprises the formation of at least one diffraction grating (118) in the second end (107) of the waveguide (104) capable of diffracting a first part (130) of the light beam towards a lower reflective layer (120) of the optical waveguide (104) arranged under the second end (107) and a second part (132) of the light beam towards an upper reflective layer (122) arranged at an upper wall of the first chamber (106).

FIG.1

FIG.2

FIG.3

FIG.4

FIG.5

z
↑
⊗ → x
y

136
134

# FIG.6A

138

# FIG.6B

140

118

# FIG.6C

142

# FIG.6D

146    144

# FIG.6E

148    148
147
150

# FIG.6F

FIG.6G

FIG.6H

FIG.6I

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 03083455 A1
- WO 2008074442 A1
- US 7304732 B1
- EP 2515096 A1

**Littérature non-brevet citée dans la description**

- **B. BAN BAKIR et al.** Electrically driven hybrid Si/III-V Fabry-Pérot lasers based on adiabatic mode transformers. *Opt. Express,* 23 Mai 2011, vol. 19 (11